(19) Europäisches Patentamt
European Patent Office
Office européen des brevets

(11) **EP 2 804 163 B1**

(12) **EUROPÄISCHE PATENTSCHRIFT**

(45) Veröffentlichungstag und Bekanntmachung des Hinweises auf die Patenterteilung:
**16.09.2015 Patentblatt 2015/38**

(51) Int Cl.:
***G08B 29/12*** *(2006.01)*

(21) Anmeldenummer: **13168203.1**

(22) Anmeldetag: **17.05.2013**

(54) **Verfahren und Vorrichtung zur Störungserkennung auf Steuerleitungen in Gefahrenmelde- und Steuerungssystemen**

Method and apparatus for detecting faults in control lines in hazard warning and control systems

Procédé et dispositif de détection des pannes dans des lignes de commande de systèmes de signalisation de danger et de systèmes de commande

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**19.11.2014 Patentblatt 2014/47**

(73) Patentinhaber: **Minimax GmbH & Co. KG**
**23840 Bad Oldesloe (DE)**

(72) Erfinder: **Stamer, Arne**
**23847 Siebenbäumen (DE)**

(56) Entgegenhaltungen:
**EP-A1- 0 405 247     EP-A1- 2 093 737**
**FR-A1- 2 932 917**

EP 2 804 163 B1

**Beschreibung**

Die Erfindung betrifft ein Verfahren zur Messung eines Leitungswiderstandes $R_L$ und somit zur Bestimmung von Störungen von Steuerleitungen in einem Gefahrenmelde- und Steuerungssystem.

Außerdem betrifft die Erfindung eine Vorrichtung zur Messung eines Leitungswiderstandes $R_L$ und somit zur Bestimmung von Störungen von Steuerleitungen in einem Gefahrenmelde- und Steuerungssystem.

An Gefahrenmelde- und Steuerungssysteme, wie zum Beispiel Brandmeldesysteme, und Löschsteuerungssysteme mit Brandmelder- und/oder Löschsteuerzentralen oder Einbruchmeldesysteme mit entsprechenden Zentralen, werden hohe Ansprüche an die Zuverlässigkeit und Betriebssicherheit der Systeme gestellt, um die Eigentümer oder Betreiber von gefährdeten Industrieanlagen, Lagereinrichtungen und sonstigen zu schützenden Objekten vor der Entstehung großer Schäden durch Brände, Chemikalien, Sabotage, Einbruch oder anderen Gefahrenszenarien rechtzeitig wie möglich zu warnen, und/oder um geeignete Gegenmaßnahmen zu ergreifen, oder automatisch Schutzvorrichtungen oder Alarmierungsmittel anzusteuern. Von besonderer Wichtigkeit sind hierbei die Ansteuerung von Aktoren, wie z.B. von Magnetventilen zur Ansteuerung von Löschanlagen, oder Aktoren wie akustische und optische Alarmierungsmittel, z.B. Blitzleuchten und Hupen oder Aktoren in der Ausprägung als Stellmotoren.

Diese Aktoren werden von Steuerungsvorrichtungen eines Gefahrenmelde- und Steuerungssystems über Versorgungsleitungen und/oder Signalleitungen, in der Regel Zweidraht- oder Mehrdrahtleitungen angesteuert, wobei im Ereignisfall eine spezifikationsgerechte Ansteuerspannung $U_A$ zu den Aktoren geschaltet wird. Der Ereignisfall kann beispielsweise ein Brandereignis, d.h. ein Branderkennungs- oder Feuererkennungssignal sein oder ein Einbruchs- oder Sabotagesignal oder ein sonstiges Gefahren- oder Warnsignal.

Daher müssen derartige Anlagen unter verschiedenen Anforderungen und Betriebsbedingungen über längere Zeiträume zuverlässig und störungsfrei arbeiten. Hierzu werden die Versorgungsleitungen und/oder Signalleitungen auf Funktionsstörungen wie Kurzschluss und Drahtbruch ständig überwacht. Solche überwachten Versorgungsleitungen und/oder Signalleitungen werden Primärleitungen oder Steuerleitungen genannt. Im Weiteren wird der Begriff Steuerleitungen verwendet. Aber auch die Überwachung auf fehlende oder defekte Aktoren ist von Bedeutung für den zuverlässigen Betrieb.

Die Überwachung von Versorgungsleitungen und/oder Signalleitungen auf Drahtbruch und Kurzschluss erfolgt z.B. in Brandmeldeanlagen bisher in der Regel über einen geringen Überwachungsstrom, der durch einen Widerstand $R_{EOL}$ am Ende der zu überwachenden Linie, insbesondere einer Brandmeldelinie, verursacht wird. Dieser Überwachungsstrom durch den Widerstand plus die Stromaufnahme der Brandmelder auf der Linie bildet den Ruhestrom, der von der Zentrale kontinuierlich überwacht wird. Sinkt dieser Ruhestrom unter einen bestimmten Wert, erkennt die Zentrale dieses als Drahtbruch auf der Linie und meldet diese Störung. Das Problem hierbei ist, dass der Widerstand $R_{EOL}$ im Verhältnis zu dem Leitungswiderstand sehr hochohmig ist, so dass durch dieses Verhältnis ein schleichender Drahtbruch, d.h. die allmähliche Erhöhung des Leitungswiderstandes um wenige Ohm, nur sehr schwer zu messen ist. Dieses wird jedoch von Normen der EN54-Reihe zwingend gefordert.

Bei langjährigem Betrieb von Gefahrenmelde- und Steuerungssysteme hat die Erkennung vom so genannten schleichenden Drahtbruch große Bedeutung. Unter schleichendem Drahtbruch wird eine langsame, sukzessive Erhöhung des Leitungswiderstandes der Versorgungs- und/oder Signalleitungen verstanden. Mögliche Ursachen für diese langsame, sukzessive Erhöhung des Leitungswiderstandes sind Umgebungseinflüsse wie z.B. Feuchtigkeit und korrosive Gase, die zur Oxidation der Kontaktstellen der Drähte und der Anschlusskontakte führen. Dieser schleichende Prozess führt zu Änderungen des Ruhestromes auf den entsprechenden Leitungen im Bereich von 0,1 mA und entspricht einer Änderung des Leitungswiderstandes von nur 0,1 bis 10 $\Omega$.

Verfahren und Vorrichtungen der eingangs genannten Art sind aus dem Stand der Technik bekannt. Aus EP 1 855 261 A1 sind ein Verfahren und eine Einrichtung zur Überwachung einer Meldelinie einer Brandmeldeanlage auf Störungen bekannt, wobei die Brandmeldeanlage im Betrieb mit einem Linienstrom beaufschlagt wird und ein durch eine TVS-Diode gebildetes Endglied aufweist. Es erfolgt eine Überwachung des Linienstroms und/oder der Linienspannung. Störungen der Meldelinie werden durch eine kurzzeitige Erhöhung und durch eine kurzzeitige Absenkung des Linienstromes erkannt. Die Auswertung erfolgt über die Spannungspegel und nicht über den Strom. Die Auswertemaßnahme wird von der Brandmeldezentrale vorgenommen, von der auch die Erhöhung und die Absenkung des Linienstromes erfolgen. Die Teilnehmer werden ständig von Seiten der Brandmelderzentrale mit der erforderlichen Betriebsspannung bzw. Ansteuerspannung versorgt.

Nachteilig ist hierbei, dass das unlineare und temperaturabhängige Verhalten von TVS-Dioden am Ende der Linie die Ermittlung des Absolutwertes des Leitungswiderstandes erschwert, insbesondere, wenn eine Widerstandszunahme von nur einigen $\Omega$ festgestellt werden soll.

Die WO 2009/087169 offenbart eine Überwachungsvorrichtung und ein Verfahren zur Überwachung des Betriebszustands von Versorgungs- und/oder Signalleitungen eines Meldesystems, insbesondere eines Brandschutz- und/oder Gefahrenmeldesystems.

Die Überwachungsvorrichtung umfasst eine Messeinrichtung zur Erzeugung eines Messsignals, eine Auswerteeinrichtung und eine steuerbare Signalquelle, welche zur Einkopplung eines Prüfsignals in die Versorgungs- und/oder Signalleitungen ausgebildet ist. Das Messsignal umfasst die Systemantwort der Versorgungs- und/oder Signalleitungen auf das Prüfsignal.

Nachteilig ist hierbei, dass das diese Vorrichtung und das Verfahren nur für relative Messungen des Leitungswiderstandes geeignet ist, und die Störungsfeststellung wie z.B. schleichender Drahtbruch immer ein Einmessen des Systems bei der Inbetriebnahme erfordert, der ermittelte Wert der Systemantwort wird abgespeichert und bildet den Referenzwert für die nachfolgenden Überwachungsmessungen. Somit können erhöhte Leitungswiderstandswerte aufgrund Fehlerhafter Installation nicht erkannt werden.

Das Dokument FR 2 932 917 A1 offenbart eine Sicherheitsanlage mit einer Alarmzentrale, einer zweiadrigen Leitung, und einem Leitungsendmodul, wobei die Alarmzentrale mit einem ersten Ende der Leitung verbunden ist und das Leitungsendmodul (Überwachungsmodul) mit einem zweiten Ende der Leitung verbunden ist und mehrere Peripheriegeräte zwischen den Adern der Leitung parallel geschaltet sind. Die Alarmzentrale aus D1 umfasst eine Steuereinheit. Stromversorgungsmittel und Messmittel, wobei die Messmittel von der Steuereinheit dahingehend gesteuert werdern, während einer ersten Überwachungsphase einen möglichen Isolationsfehler der Leitung zu erkennen und während einer zweiten Überwachungsphase einen möglichen Flussfehler der Leitung zu erkennen. D1 offenbart eine Vorrichtung zur Erkennung von Störungen auf der Leitung der Sicherheitsanlage, die im Überwachungszustand die Leitung über die Stromversorgungsmittel der Alarmzentrale mit elektrischer Energie mit einer inversen Polung versorgt, die Peripheriegeräte inaktiv lässt und in den Überwachungsphasen zwei unterschiedliche definierte Ströme von Seiten der Alarmzentrale in die Leitung einspeist. Das Leitungsendmodul kann zwei Impedanzzustände einnehmen, die über einen Sensor zur Erkennung eines Phasenänderungssignals und einer Verzögerungsschaltung eingestellt werden. Weiterhin offenbart FR 2 932 917 A1, dass das Leitungsendmodul mit einem Energiespeicher ausgestattet ist, der ausschließlich dazu vorgesehen ist, die aktiven Komponenten des Leitungsendmoduls zu versorgen.

Das Dokument EP 2 093 737A1, offenbart ein aktives Linienabschlussmodul zur Überwachung einer Leitungsimpedanz von elektrischen Anlagen, insbesondere für den Einsatz am Ende von Brandmeldelinien, wobei zwischen den zu überwachenden Leitungen eine Konstantstrom - senke mit Leuchtanzeige, ein Spannungsregler und ein intelligenter Elektronikbaustein so angeordnet sind, dass der intelligente Elektronikbaustein mittels einer Leitung mit der Konstantstromsenke verbunden ist.

Nachteilig am Stand der Technik sind:

- die fehlende oder ungenaue absolute Bestimmung des Leitungswiderstandes im Bereich von mΩ bis einige Ω.

- bisherige Verfahren und Vorrichtungen sind kostenaufwendig;

- die Komplexität von Überwachungsvorrichtungen mit integrierter Mess- und Auswerteeinrichtungen in der Überwachungseinrichtung, welche am Ende einer Versorgungs- und/oder Signalleitung angeordnet sind, entfernt von der versorgenden Zentrale, mit entsprechenden Umwelteinflüssen, macht diese Überwachungsvorrichtungen anfällig gegen EMV-Einflüsse oder erfordert kostenaufwendige schaltungstechnische Aufwendungen um diese zu unterdrücken;

- Teilnehmer an der Versorgungs- und/oder Signalleitung verfälschen die Messung des Leitungswiderstandes;

- Während der Leitungswiderstandsmessung können Spannungsschwankungen auf den Versorgungs- und/oder Signalleitungen die Leitungswiderstandsbestimmung verfälschen;

- Fehlende oder ungenaue Verfahren und Vorrichtungen zur Messung des Drahtbruchs, vom schleichenden bis zum vollständigen Drahtbruch.

Der Erfindung liegt die Aufgabe zugrunde, ein verbessertes Verfahren zur Messung des Leitungswiderstandes $R_L$ und zur Bestimmung von Störungen von Steuerleitungen zwischen einer Steuerungsvorrichtung und einem Aktor zu schaffen, welches mindestens ein Nachteil aus dem bekannten Stand der Technik beseitigt.

Weiterhin liegt der Erfindung die Aufgabe zugrunde, eine verbesserte Vorrichtung zur Messung des Leitungswiderstandes $R_L$ und zur Bestimmung von Störungen von Steuerleitungen zwischen einer Steuerungsvorrichtung und einem Aktor zu schaffen, welche mindestens einen Nachteil aus dem bekannten Stand der Technik beseitigt.

Das erfindungsgemäße Verfahren überwindet des Problem herkömmlicher Verfahren mit einem Endwiderstand $R_{EOL}$, welcher im Verhältnis zum Leitungswiderstand $R_L$ sehr hochohmig ist, und dadurch keine geringfügigen Änderungen des Leitungswiderstandes $R_L$ im Bereich mΩ bis einige Ω messbar sind.

Die erfindungsgemäße Vorrichtung besteht aus zwei Funktionsteilen, der Steuerungsvorrichtung und dem Überwachungsmoduls, welches am Ende der Steuerleitungen an oder in einem Aktor angeordnet ist. Der Anfang der Steuerleitungen ist mit Kontakten der Steuerungsvorrichtung elektrisch verbunden. Das Ende der Steuerleitungen ist mit den Anschlusskontakten am Überwachungsmodul verbunden.

Für die Anordnung des Überwachungsmoduls an oder in dem Aktor können verschieden Ausführungsformen verwendet werden. In einer bevorzugten Ausführungsform befindet sich das Überwachungsmodul in einem separaten Gehäuse und ist über elektrische Verbindungspunkte direkt am Aktor befestigt. Entscheidend ist, dass keine weiteren Leitungsverbindungen zwischen dem Überwachungsmodul und dem Aktor vorhanden sind, in welchen ein schleichender Drahtbruch auftreten kann. In einer weiteren bevorzugten Ausführungsform ist das Überwachungsmodul in das Gehäuse des Aktors integriert, als steckbares und austauschbares Modul, wobei die Schaltung des Aktors Aufnahmemittel zum Stecken des Moduls und die elektrischen Verbindungspunkte aufweist. In einer besonders bevorzugten Ausführungsform ist das Überwachungsmodul in die Schaltung des Aktors integriert und stellt somit ein integriertes Überwachungsmodul dar.

Die Steuerungsvorrichtung ist mit einer über einen Mikrocontroller zuschaltbare Konstantstromsenke, mit einer Mikrocontroller gesteuerten Umschaltvorrichtung und einer Spannungsquelle zur Erzeugung einer Überwachungsspannung $U_M$, einem Analog-Digitalwandler, kurz A/D-Wandler genannt, sowie einem Speicher ausgestattet. Anstelle der Konstantstromsenke kann auch ein zuschaltbarer Lastwiderstand angeordnet sein. Die Umschaltvorrichtung ist vorzugsweise eine elektronische mit 3 Schaltstellungen A, B und C. Die Steuerungsvorrichtung verfügt weiterhin über eine Spannungsquelle zur Erzeugung der Ansteuerspannung $U_A$ des Aktors. In der Schaltstellung A der Umschaltvorrichtung wird an den Kontakten am Anfang der Steuerleitungen die Überwachungsspannung UM angelegt. In der Schaltstellung B der Umschaltvorrichtung liegt an den Kontakten am Anfang der Steuerleitungen keine Spannung an, d.h. die Spannungsversorgung des Aktors ist in dieser Schaltstellung B von Seiten der Steuerungsvorrichtung abgeschaltet.

Der Speicher kann im Mikrocontroller integriert sein oder in einem weitern Mikrocontroller oder Mikroprozessor der Steuerungsvorrichtung, oder als separates Bauteil ausgebildet sein.

Das Überwachungsmodul weist einen Energiespeicher zur Erzeugung einer konstanten Spannungsversorgung in einem Messzeitintervall $\Delta t_M$ zur Bestimmung des Leitungswiderstandes $R_L$ auf, sowie einen Gleichrichter und einen Spannungsregler. In einer besonders bevorzugten Ausführungsform ist dieser Energiespeicher ein entsprechend dimensionierter Kondensator. In einer bevorzugten Ausführung liegt der Wert der Kapazität des Kondensators im Bereich von $1\mu F$ bis $1000\mu F$.

Dieser Energiespeicher wird im normalen Betrieb, dass heißt im Überwachungsfall, wenn keine Ansteuerung des Aktors erfolgt, mit einer Überwachungsspannung $U_M$ auf eine bestimmte Spannung aufgeladen. Diese Spannung liegt in einer vorteilhaften Ausführung im Bereich von 2 V bis 15 V, in einer besonders bevorzugten Ausführung bei 10V. Als Spannungsregler werden handelsübliche Regler im Spannungsbereich 2,5 V bis 9 V, vorzugsweise ein Spannungsregler für 3,3 V eingesetzt.

Die eigentliche Leitungsüberwachung läuft dann zyklisch, beispielsweise alle 10 s, folgendermaßen ab:

- Die Überwachungsspannung UM des Aktors wird von Seiten der Steuerungsvorrichtung abgeschaltet.

- Der Spannungsregler wird nun aus dem Energiespeicher versorgt und speist in die geregelte Spannung in die Steuerungsvorrichtung zurück. Dieser Spannungswert $U_1$ wird von der Steuerungsvorrichtung gemessen und gespeichert.

- Anschließend wird die Konstantstromsenke mit einem Stromwert $I_2$, vorzugsweise 100 mA angesteuert. Auch diese wird aus dem Energiespeicher und dem Spannungsregler versorgt.

- Es erfolgt nun eine erneute Spannungsmessung mit dem Wert $U_2$ in der Steuerungsvorrichtung

Der Wert des Leitungswiderstandes $R_L$ wird nun in der Steuerungsvorrichtung nach folgender Berechnungsvorschrift berechnet: $R_L = (U_1 - U_2)/(I_2-I_1)$. Der Stromwert $I_1$ ist in dieser Ausführungsvariante gleich Null. Die Messung kann aber alternativ auch mit zwei verschiedenen Konstantströmen durchgeführt werden.

Ein Leitungswiderstand von $R_L = 1\,\Omega$ ergibt mit den Werten $I_2 = 100$ mA, $I_1 = 0$ mA folgende Spannungsdifferenz:

$$\Delta U = R_L \cdot (I_2 - I_1) = 1\Omega \cdot 100mA = 0,1V$$

In einer bevorzugten Ausführung wird ein einfacher 8bit A/D-Wandler in der Steuerungsvorrichtung verwendet, der einen Wandelbereich von 3,3 V besitzt. Somit werden mit einer Auflösung von 13mV/Bit Leitungswiderstände in Schritten von 130 $m\Omega$ erfasst.

Erfindungsgemäß wird ein Verfahren der eingangs genanten Art mit den Merkmalen des Patentanspruchs 1 und eine Vorrichtung der eingangs genannten Art mit den Merkmalen des Patentanspruchs 11 vorgeschlagen. Die abhängigen Ansprüche beschreiben bevorzugte oder vorteilhafte Ausführungsformen der Erfindung.

Die Erfindung betrifft ein Verfahren zur Messung eines Leitungswiderstandes $R_L$ und somit zur Bestimmung von Störungen von Steuerleitungen in einem Gefahrenmelde- und Steuerungssystem. Die Steuerleitungen verbinden eine Steuerungsvorrichtung mit einem Aktor, welcher durch die Steuerungsvorrichtung im Ereignisfall mit einer Ansteuerspannung $U_A$ angesteuert wird.

Ein Ereignisfall ist in einer bevorzugten Ausführungsform z.B. die Detektion eines Feuers in einem Brandmelde- und Löschsteuerungssystem. Daraufhin erfolgt die Ansteuerung des Aktors in Form eines Magnetventils, welches ein Löschfluid zum Löschen des Feuers freigibt.

Die Steuerungsvorrichtung weist eine über einen Mikrocontroller zuschaltbare Konstantstromsenke oder einen zuschaltbaren Lastwiderstand, sowie eine Umschaltvorrichtung auf.

Die Umschaltvorrichtung wird vorzugweise durch den Mikrocontroller gesteuert und schaltet Spannungsquellen, welche in der Steuerungsvorrichtung integriert sind, auf die Steuerleitungen.

Zur Durchführung des Verfahrens wird weiterhin ein Überwachungsmodul verwendet, welches am Ende der Steuerleitungen am Aktor oder im Aktor angeordnet ist. Der Anfang der Steuerleitungen ist an der Steuerungsvorrichtung angeordnet. Bei dem erfindungsgemäßen Verfahren wird für die Bestimmung des Leitungswiderstandes $R_L$ eine konstante Spannungsversorgung in einem Messzeitintervall $\Delta t_M$ durch einen im Überwachungsmodul integrierten Energiespeicher bereitgestellt und im gesamten Messzeitintervall $\Delta t_M$ schaltet die Umschaltvorrichtung die Spannungsversorgung des Aktors von Seiten der Steuerungsvorrichtung ab.

Der Anfang der Steuerleitungen ist mit den entsprechenden Kontakten zur elektrischen Anbindung an die Steuerungsvorrichtung verbunden und das Ende der Steuerleitungen mit dem Aktor und dem Überwachungsmodul.

Die Abschaltung des Aktors von der Versorgungsspannung erfolgt durch die Mikrocontroller gesteuerte Umschaltvorrichtung. Der Aktor und die Steuerleitungen werden somit von Seiten der Steuerungsvorrichtung spannungslos geschaltet. In einer bevorzugten Ausführung der Erfindung sind zwischen der Steuerungsvorrichtung und dem Überwachungsmodul nur die Steuerleitungen mit dem Leitungswiderstand $R_L$ geschaltet und es sind keinen weiteren Widerstände oder Teilnehmer im Messstromkreis für die Bestimmung des Leitungswiderstandes vorhanden. Die Erfindung ist aber nicht auf diese Ausführungsform beschränkt. In einer weiteren vorteilhaften Ausgestaltung sind mehrerer Teilnehmer, beispielsweise Aktoren im Messstromkreis vorhanden.

Dieses Verfahren hat den Vorteil, dass eine genaue und absolute Bestimmung des Leitungswiderstandes $R_L$ im $m\Omega$ - Bereich bis einige $\Omega$ möglich ist. Der Einfluss von Spannungsschwankungen und der Einfluss weitere Teilnehmer im Messzeitintervall $\Delta t_M$, in dem der Leitungswiderstandes $R_L$ gemessen wird sind durch dieses Verfahren ausgeschlossen.

Eine vorteilhafte Ausgestaltung des Verfahrens zeichnet sich dadurch aus, dass folgende Verfahrensschritte durchgeführt werden:

- Bereitstellen einer Überwachungsspannung $U_M$ an den Kontakten der Steuerungsvorrichtung zur elektrischen Anbindung der Steuerleitungen für die Dauer eines Zeitintervalls $\Delta t_1$,

- Aufladen des Energiespeichers des Überwachungsmoduls durch die angelegte Überwachungsspannung UM für die Dauer des Zeitintervalls $\Delta t_1$,

- Abschalten der Überwachungsspannung UM nach Ablauf des Zeitintervalls $\Delta t_1$,

- Erzeugen einer geregelten Spannung $U_0$ aus dem Energiespeicher mit einem Spannungsregler,

- Messen eines resultierenden Spannungswertes $U_1$ an den Kontakten mit einem Analog-Digitalwandler und Speichern des Spannungswertes $U_1$ in einem Speicher,

- Ansteuern der Konstantstromsenke durch den Mikrocontroller und Einprägung eines Stromwertes $I_2$ in die Steuerleitungen,

- Messen eines Spannungswertes $U_2$ mit dem Analog-Digitalwandler an den Kontakten, welcher durch den eingeprägten Stromwert $I_2$ resultierend erzeugt wird,

- Speichern des Spannungswertes $U_2$ im Speicher und

- Berechnen des Leitungswiderstandes $R_L$.

Das Zu- und Abschalten und das Bereitstellen der Überwachungsspannung UM erfolgt mit Hilfe der Umschaltvorrichtung, welche über den Mikrocontroller gesteuert wird und die entsprechende Spannungsquelle zur Erzeugung der Überwachungsspannung UM auf die Steuerleitungen schaltet.

Die Umschaltvorrichtung steht zunächst in Position A. Dadurch wird das Überwachungsmodul mit der Überwachungsspannung $U_M$ versorgt. Der Energiespeicher wird über den Gleichrichter auf den Wert der Überwachungsspannung aufgeladen. Zur Bestimmung des Leitungswiderstandes $R_L$ wird die Umschaltvorrichtung durch den Mikrocontroller auf die Position B umgeschaltet. Das Überwachungsmodul ist nun seitens der Steuerungsvorrichtung spannungslos. Der Energiespeicher speist über den Spannungsregler zurück in die Steuerungsvorrichtung. Dort wird mit dem A/D-Wandler der Wert dieser Spannung gemessen und gespeichert. Dieser Wert ist $U_1$. Der Gleichrichter verhindert, dass der Energiespeicher sich direkt in die Steuerleitung zur Steuerungsvorrichtung entladen kann. Der Mikrocontroller steuert anschließend die Konstantstromsenke an, deren Konstantstrom $I_2$ dann in den Messkreis, in die Steuerleitungen eingeprägt wird. Der Energiespeicher ist so ausgelegt, dass die Ausgangsspannung des Spannungsreglers mindestens so lange konstant bleibt, bis mit dem A/D Wandler die resultierende Spannung $U_2$ in der Steuerungsvorrichtung gemessen und gespeichert wurde. Der Wert des Leitungswiderstandes $R_L$ wird nun durch den Mikrocontroller wie folgt berechnet: $R_L = (U_1 - U_2)/I_2$

In einer alternativen Ausgestaltung des Verfahrens wird der Stromwert $I_2$ über die Zuschaltung eines Lastwiderstandes erzeugt. Der Lastwiderstand ist dann anstelle der Konstantstromsenke in der Steuerungsvorrichtung angeordnet und wird über den Mikrocontroller zugeschaltet.

Eine weitere vorteilhafte Ausgestaltung des Verfahrens zeichnet sich dadurch aus, dass die Zeitdauer aller Verfahrensschritte nach Ablauf des Zeitintervalls $\Delta t_1$ das Messzeitintervall $\Delta t_M$ bestimmt.

In einer vorteilhaften Ausgestaltung des Verfahrens erfolgt die Berechnung des Leitungswiderstandes $R_L$ durch Bilden des Quotienten aus der Differenz der Spannungswerte $U_1 - U_2$ und der Differenz der zugehörigen Ströme $I_2 - I_1$. In einer bevorzugten Ausführung wird während der Messung des Spannungswertes $U_1$ kein Strom von Seiten der Steuerungsvorrichtung in die Steuerleitungen eingeprägt, so dass $I_1 = 0$ A ist. Dies vereinfacht das Verfahren und die Vorrichtung.

Da die Steuerleitungen in der Regel kontinuierlich überwacht werden müssen, erfolgt die Messung des Leitungswiderstandes $R_L$ periodisch. Bevorzugte Perioden sind im Bereich von 1 bis 60 Sekunden, aber auch beliebige andere Zeitabstände im Minuten oder Stundenbereich sind in Abhängigkeit von den Projektbedingungen realisierbar. Diese Überwachung kann aber auch aperiodisch und/oder auf Anforderung erfolgen. In einer weiteren Ausgestaltung des Verfahrens, wird die erfindungsgemäße Bestimmung des absoluten Wertes des Leitungswiderstandes $R_L$ der Steuerleitungen dazu genutzt, Störungen auf den Steuerleitungen zu signalisieren. Hierzu wird durch den Mikrocontroller bei Überschreiten eines vordefinierten Grenzwertes für den Leitungswiderstand $R_L$ ein Störungssignal erzeugt, welches eine Störung der Steuerleitungen signalisiert, welche in einer bevorzugten Ausführungsform die Erkennung eines schleichenden Drahtbruchs darstellt.

Da der absolute Wert des Leitungswiderstandes $R_L$ durch das erfindungsgemäße Verfahren bestimmt wird, kann durch eine Messung des Leitungswiderstandes nach erfolgter Installation auch eine fehlerhafte Installation mit erhöhten Leitungswiderstandswerten $R_L$ der Steuerleitungen als Störung erkannt werden.

Die erkannten Störungen der Steuerleitungen werden vorzugsweise optisch und/oder akustisch angezeigt.

Bevorzugte Zeiten und Zeitintervalle für den Ablauf des erfindungsgemäßen Verfahrens sind für das Messzeitintervall $\Delta t_M$ der Bereich von 1 bis 100 ms, besonders bevorzugt der Bereich von 1 ms bis 9 ms und für das Zeitintervall $\Delta t_1$ der Bereich von 1 s bis 100 s liegt, besonders bevorzugt der Bereich von 5 s bis 20 s. Die Zeiten und Zeitintervalle können aber mit anderen Werten den jeweiligen Erfordernissen angepasst werden.

In einer alternativen Ausgestaltung des Verfahrens kann die Messung des Leitungswiderstandes $R_L$ auch mit der herkömmlichen Überwachung durch einen Abschlusswiderstand $R_{EOL}$ kombiniert werden. Hierzu wird, wie bislang schon gängige Technik, in das Überwachungsmodul zusätzlich ein Abschlusswiderstand $R_{EOL}$ angeordnet. Im Überwachungsfall, die Umschaltvorrichtung hat die Schaltposition A, bildet dieser $R_{EOL}$ zusammen mit einem Vorwiderstand der Spannungsquelle zur Erzeugung der Überwachungsspannung UM in der Steuerungsvorrichtung und dem Innenwiderstand des Aktors einen Spannungsteiler. Die Spannung, die sich dabei im Messkreis der Steuerungsvorrichtung einstellt, wird mit dem A/D-Wandler gemessen und vom Mikrocontroller ausgewertet.

Der Vorteil dieser alternativen Ausgestaltung der erfindungsgemäßen Vorrichtung und des erfindungsgemäßen Verfahrens ist hierbei, dass der Überwachungsstrom auch durch den Aktor hindurch fließt, und dieser somit ebenfalls auf Drahtbruch überwacht ist. Der Abschlusswiderstand $R_{EOL}$ ist dabei so ausgelegt dass die Überwachungsspannung nicht zu einer ungewollten Ansteuerung des Aktors führen kann.

Bei Ansteuerung des Aktors schaltet der Mikrocontroller die Umschaltvorrichtung in Stellung C. Der Aktor wird mit der Ansteuerspannung $U_A$, beispielsweise mit 24V Gleichspannung versorgt. Ein zusätzlich im Überwachungsmodul vorhandener Schwellwertschalter sorgt zusammen mit einem zusätzlich angeordneten Schalter dafür, dass der Abschlusswiderstand kurzgeschlossen wird, und am Aktor somit die volle Ansteuerspannung $U_A$ anliegt.

Die Erfindung betrifft weiterhin eine Vorrichtung zur Messung eines Leitungswiderstandes $R_L$ und somit zur Bestimmung von Störungen von Steuerleitungen in einem Gefahrenmelde- und Steuerungssystem. Die Vorrichtung umfasst eine Steuerungsvorrichtung und ein Überwachungsmodul. Die Steuerungsvorrichtung weist eine über einen Mikrocontroller zuschaltbare Konstantstromsenke oder einen zuschaltbaren Lastwiderstand, eine Umschaltvorrichtung und eine Spannungsquelle zur Erzeugung einer Überwachungsspannung UM auf. Das Überwachungsmodul ist am Ende der Steuerleitungen an oder in einem Aktor angeordnet. Der Anfang der Steuerleitungen ist an der Steuerungsvorrichtung angeordnet.

Die Steuerungsvorrichtung steuert im Ereignisfall den Aktor über die Steuerleitungen mit einer Ansteuerspannung $U_A$ an.

Die erfindungsgemäße Vorrichtung ist so ausgebildet, dass sie für die Bestimmung des Leitungswiderstandes $R_L$ eine konstante Spannungsversorgung in einem Messzeitintervall $\Delta t_M$ durch einen im Überwachungsmodul angeordneten Energiespeicher bereitstellt. Die Umschaltvorrichtung und der Mikrocontroller sind so ausgeprägt und ausgebildet, dass im gesamten

Messzeitintervall $\Delta t_M$ die Spannungsversorgung des Aktors von Seiten der Steuerungsvorrichtung abgeschaltet ist.

Eine vorteilhafte Ausgestaltung der Erfindung zeichnet sich dadurch aus, dass die Steuerungsvorrichtung so eingerichtet und ausgebildet ist, dass die Umschaltvorrichtung über den Mikrocontroller steuerbar ist, für die Abschaltung der Spannungsversorgung des Aktors und/oder für die Ansteuerung des Aktors mit einer Ansteuerspannung $U_A$ im Ereignisfall.

Eine weitere vorteilhafte Ausgestaltung der Erfindung zeichnet sich dadurch aus, dass die Steuerungsvorrichtung zur periodischen und/oder aperiodischen Messung des Leitungswiderstandes $R_L$ und/oder zur Messung auf Anforderung ausgebildet ist.

Eine zusätzliche bevorzugte Ausgestaltung der Erfindung sieht vor, dass das Überwachungsmodul ein zum Innenwiderstand des Aktors in Reihe geschalteten Abschlusswiderstand $R_{EOL}$, einen Schwellwertschalter und einen Schalter aufweist, wobei der Abschlusswiderstand $R_{EOL}$ so ausgelegt ist, dass bei Anliegen der Überwachungsspannung UM die am Aktor anliegende Spannung unterhalb der minimalen Ansteuerspannung $U_A$ liegt.

Im Überwachungsfall (Umschaltvorrichtung in Schaltposition A) bildet bei dieser Weiterbildung der erfindungsgemäßen Vorrichtung der Abschlusswiderstand $R_{EOL}$ zusammen mit einem Vorwiderstand oder dem Innenwiderstand der Spannungsquelle zur Erzeugung einer Überwachungsspannung UM in der Steuerungsvorrichtung und dem Innenwiderstand des Aktors einen Spannungsteiler. Die Steuerungsvorrichtung ist dabei so ausgebildet, dass beim Anliegen der Überwachungsspannung, die Spannung, die sich dabei an den Kontakten zur elektrischen Anbindung der Steuerleitungen an die Steuerungsvorrichtung einstellt, mit dem Analog-Digital Wandler gemessen werden, und von dem Mikrocontroller ausgewertet werden kann. Der Vorteil bei dieser Ausführung ist, dass der Überwachungsstrom auch durch den Aktor hindurch fließt, und dieser somit ebenfalls auf Drahtbruch überwacht ist.

Der Abschlusswiderstand $R_{EOL}$ ist hierbei so ausgelegt, dass die Überwachungsspannung UM nicht zu einer ungewollten Ansteuerung des Aktors führen kann, die am Aktor anliegende Spannung liegt hierbei unterhalb der minimalen Ansteuerspannung des Aktors. Die Steuerungsvorrichtung ist in dieser Ausführungsversion so ausgebildet, dass im Ereignisfall, bei Ansteuerung des Aktors mit der Ansteuerungsspannung $U_A$, der Mikrocontroller die Umschaltvorrichtung ansteuert und die Ansteuerungsspannung $U_A$ auf die Kontakten zur elektrischen Anbindung der Steuerleitungen an die Steuerungsvorrichtung schaltet. Der Schwellwertschalter bewirkt zusammen mit dem Schalter, dass der Abschlusswiderstand $R_{EOL}$ kurzgeschlossen wird, und an dem Aktor somit die volle Ansteuerspannung $U_A$ anliegt.

Eine weitere vorteilhafte Ausgestaltung der erfindungsgemäßen Vorrichtung zeichnet sich dadurch aus, dass die Steuerungsvorrichtung so eingerichtet und ausgebildet ist, dass bei Überschreiten eines vordefinierten Grenzwertes für den Leitungswiderstand $R_L$ durch den Mikrocontroller ein Störungssignal erzeugt wird, welches eine Störung der Steuerleitungen signalisiert.

In einer bevorzugten Ausführung werden mit dem Störungssignal optische und/oder akustische Anzeigemittel angesteuert, somit ist die Steuerungsvorrichtung ausgebildet eine oder mehrere Störungsmeldungen zu erzeugen.

Der Energiespeicher der erfindungsgemäßen Vorrichtung ist bevorzugt als Kondensator ausgebildet. Dieser wird durch das Anlegen der Überwachungsspannung $U_M$ von Seiten der Steuerungsvorrichtung aufgeladen. Über einen Spannungsregler stellt dieser Kondensator eine konstante Spannungsversorgung zur Messung des Leitungswiderstandes $R_L$ zu Verfügung. In weiteren vorteilhaften Ausführungen ist der Energiespeicher als Batterie oder Akkumulator ausgebildet. Alle Energiespeicher sind so dimensioniert, dass sie die konstante Spannungsversorgung im gesamten Messzeitintervall $\Delta t_M$ zur Messung des Leitungswiderstandes $R_L$ gewährleisten.

In einer bevorzugten Ausführung stellt das Gefahrenmelde- und Steuerungssystem ein Brandmeldesystem und/oder ein Löschsteuerungssystem dar, welches mit dem Brandmeldesystem in signaltechnischer Verbindung steht. Ein Ereignisfall ist in diesem Fall die Detektion eines Feuers durch Brandmelder des Brandmeldesystems. Das Löschsteuerungssystem ist vorzugsweise als Brandmelde- und/oder Löschsteuerzentrale mit anzusteuernden Aktoren ausgebildet. Eine Ausführungsform des Aktors ist ein Magnetventil. Die Ansteuerung des Magnetventils über die Steuerleitungen durch anlegen der Ansteuerspannung $U_A$ im Ereignisfall, gibt ein Löschfluid zum Löschen des Feuers frei. Zur Gewährleistung dieser wichtigen Funktion, misst diese bevorzugte Ausführung der erfindungsgemäßen Vorrichtung den Leitungswiderstand $R_L$ der Steuerleitungen und überwacht diese auf Störungen. In dieser bevorzugten Ausführungsvariante ist es vorteilhaft, dass die Steuerungsvorrichtung als Bestandteil einer Brandmelder- und/oder Löschsteuerzentrale ausgeprägt ist.

Dies wird vorzugsweise dadurch realisiert, dass die Steuerungsvorrichtung ein Steuergruppenmodul der Brandmelder- und/oder Löschsteuerzentrale darstellt oder als Ringbusteilnehmer ausgebildet ist.

In einer weiteren alternativen Ausführung stellt die Steuerungsvorrichtung ein adressierbares Modul auf einer Ringbusleitung der Brandmelder- und/oder Löschsteuerzentrale dar.

Das Steuergruppenmodul steuert Aktoren, wie z.B. Magnetventile oder Signalgeber, akustische oder optische, Steuermagnete, Schützspulen, Motoren und vergleichbare Geräte an. Der Aktor oder die Aktoren sind mit dem Steuergruppenmodul über Steuerleitungen verbunden, über welche die erforderliche Betriebsspannung, oder die Ansteuerspannung $U_A$ für die Funktion und Aktivierung des entsprechenden Aktors im Ansteuerungsfall zur Verfügung gestellt wird. Der Ansteuerungsfall ist ein Ereignisfall wie Feuerdetektion oder ein Voralarm oder ein anderes Ereignis.

Die Steuerleitungen zum Aktor werden durch die Messung des Leitungswiderstandes $R_L$ auf Drahtbruch und Kurzschluss überwacht. Die Überwachung umfasst vorzugsweise zusätzlich das Vorhandensein und den ordnungsgemäßen Zustand der angeschlossenen Aktoren.

Bei Detektion eines Brandes, erfasst ein entsprechendes Funktionsmodul der Brandmelderzentrale das Signal eines Brandmelders, danach wird über eine zentrale Rechnereinheit der Brandmelderzentrale ein Befehl an das Steuergruppenmodul gesendet, welches dann ein Magnetventil an einer Löschvorrichtung schaltet und damit ein Löschfluid freigibt welches über Düsen zum Löschen des Feuers gelangt.

Das Steuergruppenmodul und das Ringbusteilnehmermodul sind mit jeweils mindestens einem programmierbaren Mikrocontroller, Speicher, A/D-Wandler und mindestens einem elektronischen Schaltungskreis oder Messschaltung zur Überwachung von Steuerleitungen und/oder Signalleitungen auf Drahtbruch und Kurzschluss ausgerüstet.

Das Ringbusteilnehmermodul ist mit mindestens einer Teilnehmerschleife verbunden. Über eine Verbindungsleitung, eine Signalleitung, welche sowohl die Energieversorgung als auch die Datenübertragung sicherstellt, sind einzeladressierbare Teilnehmer, so genannte Ringbusteilnehmer angeschlossen. Ringbussteilnehmer sind z.B. externe Schalt- oder Geberelemente Brandmelder, Gefahrenmelder, Aktoren und Steuerungsvorrichtungen, welche als adressierbares Modul ausgebildet sind. Bei der Ringbustechnologie ist die Signalleitung in einer vorteilhaften Ausführung als geschlossene Ringbusleitung ausgeführt. Diese hat den Vorteil, dass bei Unterbrechung dieser Signalleitung, z. B. bei Drahtbruch, die Energieversorgung und die Kommunikation mit den adressierbaren Teilnehmern von beiden Seiten des ehemaligen Ringes über das Ringbusteilnehmermodul sichergestellt wird. In einer anderen Ausführung ist diese Signalleitung als eine Stichleitung für Ringbusteilnehmer ausgelegt.

In einer Ausführungsausgestaltung der Erfindung ist die Steuerungsvorrichtung als adressierbares Modul und somit als Ringbusteilnehmer ausgebildet.

Die Datenkommunikation zwischen dem Ringbusteilnehmermodul und den Ringbusteilnehmern erfolgt in einer vorteilhaften Ausführung über die Signalleitungen und über eine Datentransfersteuerung, vorzugsweise in bitserieller Form und im Halbduplex-Verfahren. Dabei sind die Dateninformationen auf die von dem Ringbusteilnehmermodul bereitgestellte Versorgungsspannung aufmoduliert.

Die Schaltung der elektronischen Flachbaugruppe des Ringbusteilnehmermoduls und die Programmierung des zugehörigen Prozessors dieses Moduls sind so eingerichtet und ausgebildet, dass die Signalleitungen kontinuierlich oder in regelmäßigen Zeitabständen auf Drahtbruch und Kurzschluss untersucht werden. Wird ein Drahtbruch oder Kurzschluss festgestellt, wird dies über die Busverbindung zur zentralen Steuereinheit gesendet, das Ereignis im Speicher abgelegt und die zentrale Steuereinheit steuert die Anzeige des Drahtbruchs oder des Kurzschlusses an der Anzeige- und Bedieneinheit.

Ein weiterer Gegenstand der Erfindung ist eine Löschsteuerzentrale mit einer Vorrichtung zur Messung eines Leitungswiderstandes $R_L$ und somit zur Bestimmung von Störungen von Steuerleitungen in einem Gefahrenmelde- und Steuerungssystem. Die Vorrichtung weist eine Steuerungsvorrichtung, in welcher eine über einen Mikrocontroller zuschaltbare Konstantstromsenke oder ein zuschaltbarer Lastwiderstand, eine Umschaltvorrichtung und eine Spannungsquelle zur Erzeugung einer Überwachungsspannung UM angeordnet sind, sowie ein Überwachungsmodul auf. Das Überwachungsmodul ist am Ende der Steuerleitungen an oder in einem Aktor angeordnet ist, wobei der Anfang der Steuerleitungen an der Steuerungsvorrichtung angeordnet ist. Die Löschsteuerzentrale ist besonders dadurch gekennzeichnet, dass das Überwachungsmodul einen Energiespeicher zur Erzeugung einer konstanten Spannungsversorgung in einem Messzeitintervall $\Delta t_M$ zur Bestimmung des Leitungswiderstandes $R_L$ aufweist und dass die Umschaltvorrichtung und der Mikrocontroller so ausgeprägt und ausgebildet sind, dass im gesamten Messzeitintervall $\Delta t_M$ die Spannungsversorgung des Aktors von Seiten der Steuerungsvorrichtung abgeschaltet ist.

Vorteilhafte Ausgestaltungen der erfindungsgemäßen Löschsteuerzentrale beinhalten eine Vorrichtung zur Messung eines Leitungswiderstandes $R_L$ und somit zur Bestimmung von Störungen von Steuerleitungen nach einem der Ansprüche 10 bis 15.

Ein weiterer Gegenstand der Erfindung ist ein Verfahren zur Überwachung von Löschanlagen, insbesondere zur Bestimmung von Störungen von Steuerleitungen durch Messung eines Leitungswiderstandes $R_L$, wobei die Steuerleitungen eine Steuerungsvorrichtung mit einem Aktor verbinden und die Steuerungsvorrichtung im Ereignisfall den Aktor mit einer Ansteuerspannung $U_A$ ansteuert, und am oder im Aktor ein Überwachungsmodul am Ende der Steuerleitungen angeordnet ist, wobei ferner die Steuerungsvorrichtung eine über einen Mikrocontroller zuschaltbare Konstantstromsenke oder einen zuschaltbaren Lastwiderstand und eine Umschaltvorrichtung aufweist und der Anfang der Steuerleitungen an der Steuerungsvorrichtung angeordnet ist. Das Verfahren ist besonders dadurch gekennzeichnet, dass für die Bestimmung des Leitungswiderstandes $R_L$ eine konstante Spannungsversorgung in einem Messzeitintervall $\Delta t_M$ durch einen im Überwachungsmodul integrierten Energiespeicher bereitgestellt wird und im gesamten Messzeitintervall $\Delta t_M$ schaltet die Umschaltvorrichtung die Spannungsversorgung des Aktors von Seiten der Steuerungsvorrichtung ab.

Vorteilhafte Ausgestaltungen des erfindungsgemäßen Verfahrens zur Überwachung von Löschanlagen nutzen das Verfahren zur Messung des Leitungswiderstandes $R_L$ und somit zur Bestimmung von Störungen von Steuerleitungen in einem Löschsteuerungssystem nach einem der Ansprüche 2 bis 8.

Mit dem erfindungsgemäßen Verfahren und der erfindungsgemäßen Vorrichtung ergeben sich einen Reihe von Vorteilen:

- Der Leitungswiderstandswert $R_L$ kann mit dem vorgeschlagenen Verfahren im Milliohm (m $\Omega$) - Bereich erfasst werden. Wird beispielsweise eine Stromsenke von 100 mA verwendet, entspricht eine gemessene Spannungsdifferenz von 100 mV einem Leitungswiderstand von 1 $\Omega$. Somit können mit einem preisgünstigen 8 bit A/D-Wandler Werte in der Größenordnung von 10 m$\Omega\square$ aufgelöst werden. Die Anforderungen zur Erkennung von schleichenden Drahtbrüchen, z.B. die aus der EN54 Normenreihe können mit wenig Aufwand und kostengünstig erfüllt werden.

- Die Vorrichtung und das Verfahren sind kostengünstig, da im Vergleich zur derzeitigen Technik nur wenige Bauteile hinzu kommen. Die Auswerteschaltung ist in der Steuerungsvorrichtung angeordnet. Die zur Spannungsmessung notwendigen Bauteile und der zur Auswertung notwendige Mikrocontroller der Steuerungsvorrichtung können genutzt werden.

- Das erfindungsgemäße Verfahren ist kompatibel zu der derzeit verwendeten Technik. Das Überwachungsmodul ist in einer vorteilhaften Ausführung so ausgebildet, das es alte Module in oder an Aktoren durch Austausch ersetzen kann.

- Der Leitungswiderstand $R_L$ wird messtechnisch als absoluter Widerstandswert erfasst und kann zur Anzeige gebracht werden.

- Die geringe Komplexität des Überwachungsmoduls mit wenigen Bauteilen, welche am Ende einer Versorgungs- und/oder Signalleitung, einer Steuerleitung angeordnet ist, und entsprechenden Umwelteinflüssen ausgesetzt ist, macht die erfindungsgemäße Vorrichtungen unanfälliger gegenüber EMV-Einflüssen.

- Das erfindungsgemäße Verfahren garantiert, dass während der Leitungswiderstandsmessung keine Spannungsschwankungen auf den Versorgungs- und/oder Signalleitungen die Leitungswiderstandsbestimmung verfälschen.

Weitere vorteilhafte oder zweckmäßige Merkmale und Ausgestaltungen der Erfindung ergeben sich aus den Unteransprüchen sowie aus der Beschreibung. Eine besonders bevorzugte Ausführungsform wird anhand der beigefügten Zeichnungen näher erläutert. In den Zeichnungen zeigen:

Fig. 1      ein schematisches Blockschaltbild der Vorrichtung zur Messung des Leitungswiderstandes $R_L$;

Fig. 2      ein schematisches Blockschaltbild eines zweiten Ausführungsbeispieles;

Fig. 3      eine schematische Darstellung der Steuerungsvorrichtung als Steuergruppenmodul einer Brandmelder- und/oder Löschsteuerzentrale;

Fig. 4      eine schematische Darstellung der Steuerungsvorrichtung als adressierbares Modul auf einer Ringbusleitung einer Brandmelderund/oder Löschsteuerzentrale.

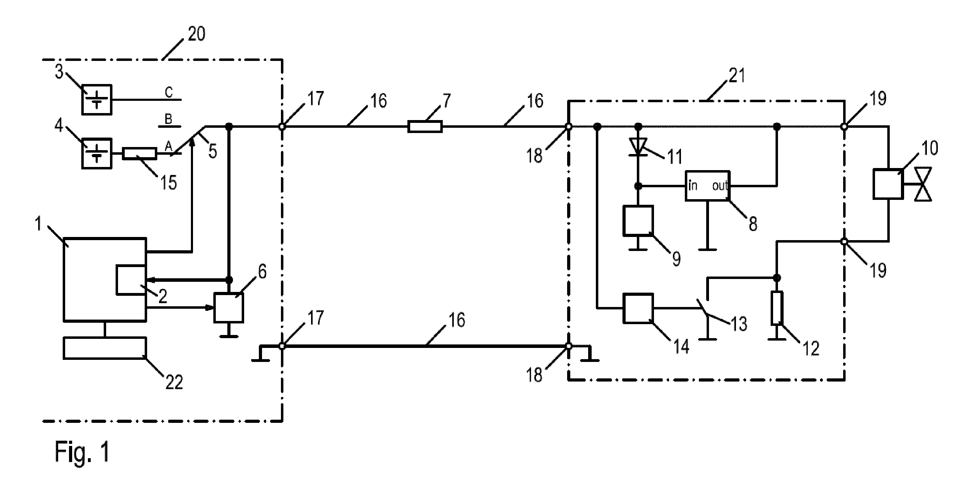

Eine besonders bevorzugte Ausgestaltung der Vorrichtung zur Messung eines Leitungswiderstandes $R_L$ 7 und somit zur Bestimmung von Störungen von Steuerleitungen 16 in einem Gefahrenmelde- und Steuerungssystem ist schematisch in der Fig. 1 dargestellt. Die Vorrichtung besteht aus zwei Funktionsteilen, der Steuerungsvorrichtung 20 und dem Überwachungsmoduls 21, welches am Ende der Steuerleitungen 16 an oder in einem Aktor 10 angeordnet ist, wobei der Anfang der Steuerleitungen 16 an den Kontakten 17 an der Steuerungsvorrichtung 20 angeordnet ist. Das Ende der Steuerleitungen ist an den Anschlusskontakten 18 mit dem Überwachungsmodul 21 verbunden.

Für die Anordnung des Überwachungsmoduls 21 an oder in dem Aktor 10 werden verschieden Ausführungsformen verwendet, die nicht dargestellt sind. In einer bevorzugten Ausführungsform befindet sich das Überwachungsmodul 21 in einem separaten Gehäuse und ist über die elektrischen Verbindungspunkte 19 direkt am Aktor 10 befestigt. Entscheidend ist, dass keine weiteren Leitungsverbindungen zwischen dem Überwachungsmodul 21 und Aktor 10 vorhanden sind, in welchen ein schleichender Drahtbruch auftreten kann. In einer weiteren bevorzugten Ausführungsform ist das Überwachungsmodul 21 in das Gehäuse des Aktors 10 integriert, als steckbares und austauschbares Modul, wobei die Schaltung des Aktors 10 Aufnahmemittel zum Stecken des Moduls und die elektrischen Verbindungspunkte 19 aufweist. In einer besonders bevorzugten Ausführungsform ist das Überwachungsmodul 21 in die Schaltung des Aktors 10 integriert und stellt somit ein integriertes Überwachungsmodul 21 dar. Sowohl für die Ausführungsvariante des Überwachungsmoduls 21 als austauschbares Modul als auch als integriertes Überwachungsmodul 21 befinden sich die Anschlusskontakte 18 am oder im Gehäuse des Aktors 10.

Die Steuerungsvorrichtung 20 weist eine über einen Mikrocontroller 1 zuschaltbare Konstantstromsenke 6, eine Umschaltvorrichtung 5 und eine Spannungsquelle 4 zur Erzeugung einer Überwachungsspannung UM auf. Anstelle der Konstantstromsenke 6 kann auch ein zuschaltbarer Lastwiderstand angeordnet sein. Weiterhin sind in der Steuerungsvorrichtung 20 eine Umschaltvorrichtung 5, vorzugsweise eine elektronische mit drei Schaltstellungen A, B und C und ein Speicher 22 angeordnet. Die Steuerungsvorrichtung 20 verfügt weiterhin über eine Spannungsquelle 3 zur Erzeugung der Ansteuerspannung $U_A$ des Aktors 10. In der Schaltstellung A der Umschaltvorrichtung 5 wird an den Kontakten 17, am Anfang der Steuerleitungen 16 die Überwachungsspannung UM angelegt. In der Schaltstellung B der Umschaltvorrichtung 5 liegt an den Kontakten 17, am Anfang der Steuerleitungen 16 keine Spannung an, d.h. die Spannungsversorgung des Aktors 10 ist von Seiten der Steuerungsvorrichtung 20 abgeschaltet.

Der Speicher 22 kann im Mikrocontroller 1 integriert sein oder in einem weiteren Mikrokontroller oder Mikroprozessor der Steuerungsvorrichtung 20, oder wie dargestellt als separates Bauteil ausgebildet sein.

Wie in der Fig. 1 dargestellt, weist das Überwachungsmodul 21 einen Energiespeicher 9 zur Erzeugung einer konstanten Spannungsversorgung in einem Messzeitintervall $\Delta t_M$ zur Bestimmung des Leitungswiderstandes $R_L$ 7 auf. In einer besonders bevorzugten Ausführungsform ist ein entsprechend dimensionierter Kondensator dieser Energiespeicher 9.

Die Umschaltvorrichtung 5 und der Mikrocontroller 1 sind so ausgeprägt und ausgebildet, dass im gesamten Messzeitintervall $\Delta t_M$ die Spannungsversorgung des Aktors 10 von Seiten der Steuerungsvorrichtung 20 abgeschaltet ist. Hierzu ist eine entsprechende Software im Mikrocontroller 1 implementiert. Die Umschaltvorrichtung 5 hat hierbei die in Fig. 1 dargestellt Schaltposition B.

Die Steuerungsvorrichtung 20 ist so eingerichtet und ausgebildet, dass die Umschaltvorrichtung 5 über den Mikrocontroller 1 steuerbar ist, für die Abschaltung der Spannungsversorgung des Aktors 10 und/oder für die Ansteuerung des Aktors 10 mit einer Ansteuerspannung $U_A$ im Ereignisfall. Für die Bereitstellung der Ansteuerspannung $U_A$ wird die Umschaltvorrichtung 5 in die Schaltposition C geschaltet.

Durch die im Mikrocontroller 1 implementierte Software ist die Steuerungsvorrichtung 20 so ausgebildet, dass der Leitungswiderstandes $R_L$ 7 periodisch und/oder aperiodisch gemessen wird und/oder auf Anforderung gemessen wird.

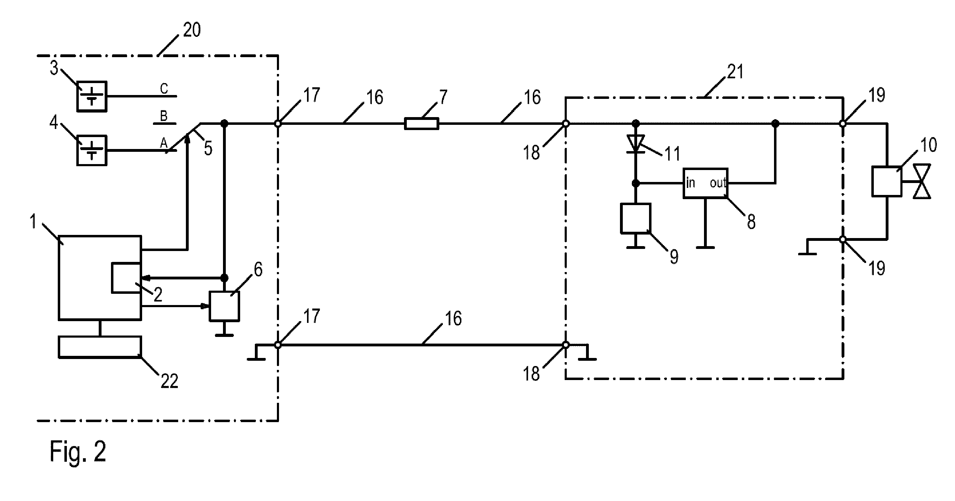

In Fig. 2 ist eine alternative Ausgestaltung der erfindungsgemäßen Vorrichtung zur Messung des Leitungswiderstandes $R_L$ 7 schematisch dargestellt. Im Überwachungsmodul 21 ist zusätzlich ein Abschlusswiderstand $R_{EOL}$ 12 in Reihenschaltung zum Innenwiderstand des Aktors 10 angeordnet. Im dargestellten Überwachungsfall hat die Umschaltvorrichtung 5 die Schaltposition A und der Abschlusswiderstand $R_{EOL}$ 12 bildet zusammen mit einem Vorwiderstand 15 der Spannungsquelle 4 zur Erzeugung der Überwachungsspannung UM in der Steuerungsvorrichtung 20 und dem Innenwiderstand des Aktors 10 einen Spannungsteiler. Die Spannung, die sich dabei im Messkreis der Steuerungsvorrichtung 20 einstellt, wird mit dem A/D-Wandler 2 gemessen und vom Mikrocontroller 1 ausgewertet.

In beiden Ausführungsvarianten der erfindungsgemäßen Vorrichtung aus Fig. 1 und Fig. 2 schaltet der Mikrocontroller 1 die Umschaltvorrichtung 5 in Stellung C bei Ansteuerung des Aktors 10 im Ereignisfall. Der Aktor 10 wird hierbei mit der Ansteuerspannung $U_A$, beispielsweise mit 24V Gleichspannung versorgt.

In der Ausführungsvariante, die in Fig. 2 dargestellt ist, sorgt ein zusätzlich im Überwachungsmodul 21 angeordneter Schwellwertschalter 14 zusammen mit einem zusätzlich angeordneten Schalter 13 dafür, dass der Abschlusswiderstand $R_{EOL}$ 12 kurzgeschlossen wird und am Aktor 10 bei Ansteuerung im Ereignisfall somit die volle Ansteuerspannung $U_A$ anliegt.

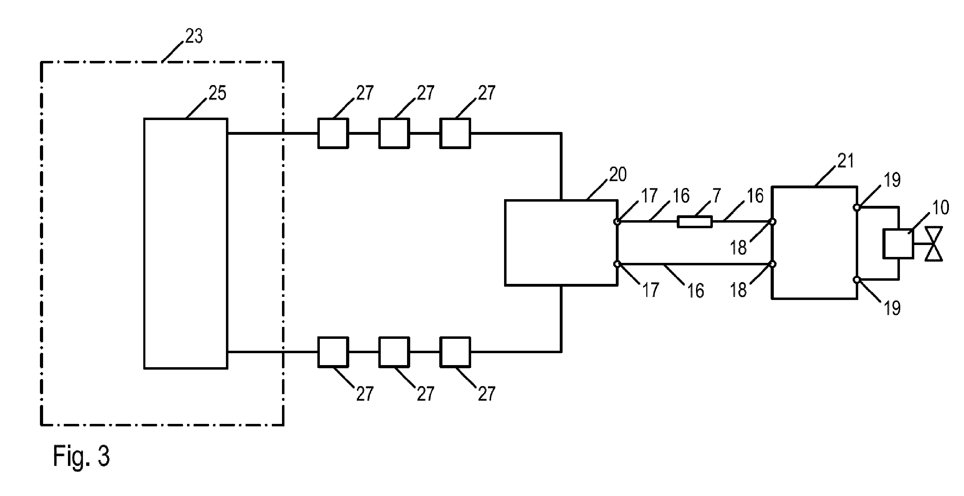

Eine weitere Ausführungsvariante der erfindungsgemäßen Vorrichtung ist in Fig. 3 dargestellt. Die Steuerungsvorrichtung 20 ist hierbei als ein adressierbares Modul auf einer Ringbusleitung der Brandmelder- und/oder Löschsteuerzentrale 23 ausgebildet. Die Ringbusleitung ist versorgungs- und signaltechnisch mit dem Ringbusteilnehmermodul 25 verbunden, welches vorzugsweise in der Brandmelder- und/oder Löschsteuerzentrale 23 angeordnet ist. Auf dieser Ringbusleitung sind weitere adressierbare Ringbusteilnehmer 27, vorzugsweise Brandmelder angeordnet. Die Steuerungsvorrichtung 20, ausgebildet als ein adressierbares Modul ist somit selbst ein Ringbusteilnehmer 27. Dies hat den Vorteil, dass Störungsmeldungen von einem festgestellten schleichenden Drahtbruch mit einer Adresse versehen sind und somit die Zuordnung der Störungsmeldung für eine definierte Steuerleitung im Gebäude an einem bestimmten Ort vorliegt.

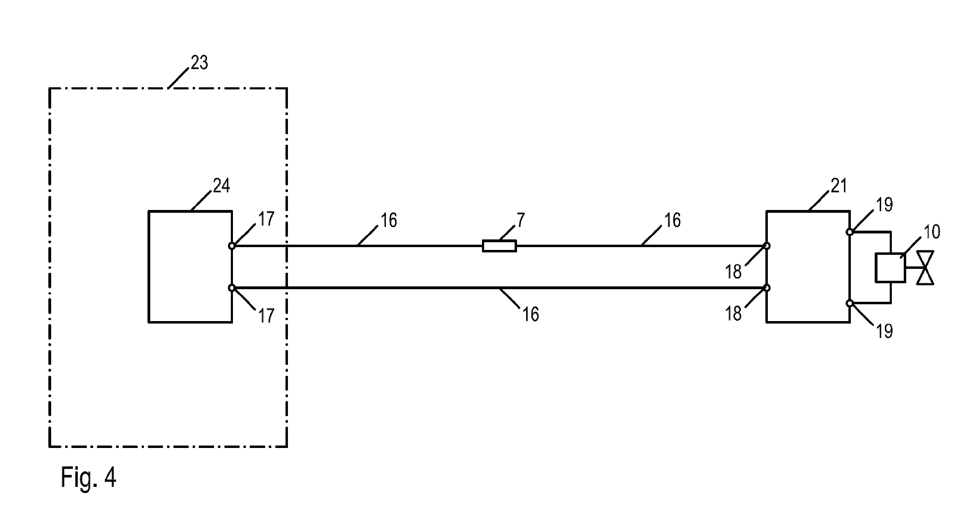

In Fig. 4 ist eine weitere vorteilhafte Ausführung der erfindungsgemäßen Vorrichtung schematisch dargestellt. Die Steuerungsvorrichtung 20 stellt hierbei ein Steuergruppenmodul 24 einer Brandmelder- und/oder Löschsteuerzentrale 23 dar und ist somit als Bestandteil einer Brandmelder- und/oder Löschsteuerzentrale 23 ausgeprägt.

An Hand der Darstellung der Funktionselemente der erfindungsgemäßen Vorrichtung in der Fig. 1, wird nun das erfindungsgemäße Verfahren in einer besonders bevorzugten Ausführung erläutert.

In der Schaltstellung A der Umschaltvorrichtung 5 wird der Energiespeicher 9 des Überwachungsmoduls 21 im normalen Betrieb, dass heißt im Überwachungsfall, wenn keine Ansteuerung des Aktors 10 im Ereignisfall erfolgt, mit einer Überwachungsspannung $U_M$ auf eine bestimmte Spannung aufgeladen. Diese Überwachungsspannung UM wird von der Spannungsquelle 4 bereitgestellt. Die Messung des Leitungswiderstandes $R_L$ 7 und somit die Leitungsüberwachung auf Störung läuft bevorzugt zyklisch ab:

- Die Überwachungsspannung UM des Aktors 10 wird von Seiten der Steuerungsvorrichtung 20, durch schalten der Umschaltvorrichtung 5 in die Schaltstellung B abgeschaltet. Die Umschaltvorrichtung 5 verbleibt in dieser Schaltstellung B während des gesamten Messzeitintervalls $\Delta t_M$. Das Messzeitintervall $\Delta t_M$ ist hierbei die Zeitdauer zwischen den Umschaltzeitpunkten von der Schaltposition A in die Schaltposition B der Umschaltvorrichtung 5. In diesem Messzeitintervall $\Delta t_M$. werden die Spannungen $U_1$ und $U_2$ gemessen.

- Der Spannungsregler 8 des Überwachungsmoduls 21 wird nun aus dem Energiespeicher 9 versorgt und speist die geregelte konstante Spannung in die Steuerungsvorrichtung 20 zurück. Dieser Spannungswert $U_1$ wird von der Steuerungsvorrichtung 20 mit Hilfe des A/D-Wandlers 2 und des Mikrocontrollers 1 gemessen und im Speicher 22 gespeichert.

- Anschließend wird die Konstantstromsenke 6 mit einem Stromwert $I_2$ angesteuert. Auch diese Konstantstromsenke 6 wird aus dem Energiespeicher 9 und dem Spannungsregler 8 versorgt.

- Es erfolgt nun eine erneute Spannungsmessung mit dem Wert $U_2$ in der Steuerungsvorrichtung 20 und der Mikrocontroller 1 berechnet nach einer vorgegeben Berechnungsvorschrift den Leitungswiderstand $R_L$ 7.

Das Verfahren zur Messung eines Leitungswiderstandes $R_L$ 7 und somit zur Bestimmung von Störungen von Steuerleitungen 16 in einem Gefahrenmelde- und Steuerungssystem ist besonders dadurch gekennzeichnet, dass für die Bestimmung des Leitungswiderstandes $R_L$ 7 eine konstante Spannungsversorgung in einem Messzeitintervall $\Delta t_M$ durch einen im Überwachungsmodul 21 integrierten Energiespeicher 9 bereitgestellt wird und im gesamten Messzeitintervall $\Delta t_M$ die Umschaltvorrichtung 5 die Spannungsversorgung des Aktors 10 von Seiten der Steuerungsvorrichtung 20 abschaltet.

Im Detail werden folgende wesentlichen Verfahrenschritte durchgeführt:

- Bereitstellen einer Überwachungsspannung UM an den Kontakten 17 der Steuerungsvorrichtung 20 zur elektrischen Anbindung der Steuerleitungen 16 für die Dauer eines Zeitintervalls $\Delta t_1$.

- Aufladen des Energiespeichers 9 des Überwachungsmoduls 21 durch die angelegte Überwachungsspannung UM für die Dauer des Zeitintervalls $\Delta t_1$,

- Abschalten der Überwachungsspannung UM nach Ablauf des Zeitintervalls $\Delta t_1$,

- Erzeugen einer geregelten Spannung $U_0$ aus dem Energiespeicher 9 mit einem Spannungsregler 8,

- Messen eines resultierenden Spannungswertes $U_1$ an den Kontakten 17 mit einem A/D-Wandler 2 und speichern des Spannungswertes $U_1$ in einem Speicher 22,

- Ansteuern der Konstantstromsenke 6 durch den Mikrocontroller 1 und Einprägung eines Stromwertes $I_2$ in die Steuerleitungen 16,

- Messen eines Spannungswertes $U_2$ mit dem A/D-Wandler 2 an den Kontakten 17, welcher durch den eingeprägten Stromwert $I_2$ resultierend erzeugt wird,

- Speichern des Spannungswertes $U_2$ im Speicher 22, und

- Berechnen des Leitungswiderstandes $R_L$ 7.

Das Bereitstellen der Überwachungsspannung UM erfolgt vorzugsweise durch Schalten der Umschaltvorrichtung 5.

Dieses erfindungsgemäße Verfahren, kann vorzugsweise mit allen in den Fig. 1 bis 4 dargestellten Ausführungsvarianten der erfindungsgemäßen Vorrichtung durchgeführt werden, ist aber nicht auf diese Vorrichtungen beschränkt.

**Bezugszeichenliste**

| | |
|---|---|
| 1 | Mikrocontroller |
| 2 | A/D-Wandler |
| 3 | Spannungsquelle zur Erzeugung der Ansteuerspannung $U_A$ des Aktors 10 |
| 4 | Spannungsquelle zur Erzeugung der Überwachungsspannung UM |
| 5 | Umschaltvorrichtung |
| 6 | Konstantstromsenke |
| 7 | Leitungswiderstand $R_L$ |
| 8 | Spannungsregler |
| 9 | Energiespeicher |
| 10 | Aktor |
| 11 | Gleichrichter |
| 12 | Abschlusswiderstand $R_{EOL}$ |
| 13 | Schalter |
| 14 | Schwellwertschalter |
| 15 | Vorwiderstand |
| 16 | Steuerleitungen |
| 17 | Kontakte zum Anschluss der Steuerleitungen an die zentrale Steuervorrichtung 20 |
| 18 | Anschlusskontakte am Überwachungsmodul 21 |

für die Steuerleitungen 16

19    elektrische Verbindungspunkte des Überwachungsmoduls 21 mit dem Aktor 10

20    Steuerungsvorrichtung

21    Überwachungsmodul

22    Speicher

23    Brandmelder- und/oder Löschsteuerzentrale

24    Steuergruppenmodul

25    Ringbusteilnehmermodul

27    Ringbusteilnehmer

**Patentansprüche**

1. **Verfahren** zur Messung eines Leitungswiderstandes $R_L$ (7) und somit zur Bestimmung von Störungen von Steuerleitungen (16) in einem Gefahrenmelde- und Steuerungssystem, wobei die Steuerleitungen (16) eine Steuerungsvorrichtung (20) mit einem Aktor (10) verbinden, wobei die Steuerungsvorrichtung (20) im Ereignisfall den Aktor (10) mit einer Ansteuerspannung $U_A$ ansteuert und im Überwachungsfall den Aktor (10) mit einer Überwachungsspannung UM, versorgt, wobei am oder im Aktor (10) ein Überwachungsmodul (21) am Ende der Steuerleitungen (16) angeordnet ist, wobei ferner die Steuerungsvorrichtung (20) eine über einen Mikrocontroller (1) zuschaltbare Konstantstromsenke (6) oder einen zuschaltbaren Lastwiderstand und eine Umschaltvorrichtung (5) aufweist und der Anfang der Steuerleitungen (16) an der Steuerungsvorrichtung (20) angeordnet ist, wobei für die Bestimmung des Leitungswiderstandes $R_L$ (7) eine konstante Spannungsversorgung in einem Messzeitintervall $\Delta t_M$ durch einen im Überwachungsmodul (21) integrierten Energiespeicher (9) bereitgestellt und in die Steuerungsvorrichtung (20) zurückgespeist wird und im gesamten Messzeitintervall $\Delta t_M$ die Umschaltvorrichtung (5) die Spannungsversorgung des Aktors (10) mit der Überwachungsspannung $U_M$ von Seiten der Steuerungsvorrichtung (20) abschaltet.

2. Verfahren nach Ansprüche 1, **dadurch gekennzeichnet, dass** folgende Verfahrenschritte durchgeführt werden:

     • Bereitstellen einer Überwachungsspannung $U_M$ an den Kontakten (17) der Steuerungsvorrichtung (20) zur elektrischen Anbindung der Steuerleitungen (16) für die Dauer eines Zeitintervalls $\Delta t_1$.
     • Aufladen des Energiespeichers (9) des Überwachungsmoduls (21) durch die angelegte Überwachungsspannung UM für die Dauer des Zeitintervalls $\Delta t_1$,
     • Abschalten der Überwachungsspannung UM nach Ablauf des Zeitintervalls $\Delta t_1$,
     • Erzeugen einer geregelten Spannung $U_0$ aus

dem Energiespeicher (9) mit einem Spannungsregler (8),
     • Messen eines resultierenden Spannungswertes $U_1$ an den Kontakten (17) mit einem A/D-Wandler (2) und Speichern des Spannungswertes $U_1$ in einem Speicher (22),
     • Ansteuern der Konstantstromsenke (6) durch den Mikrocontroller (1) und Einprägung eines Stromwertes $I_2$ in die Steuerleitungen (16),
     • Messen eines Spannungswertes $U_2$ mit dem A/D-Wandler (2) an den Kontakten (17), welcher durch den eingeprägten Stromwert $I_2$ resultierend erzeugt wird,
     • Speichern des Spannungswertes $U_2$ im Speicher (22), und
     • Berechnen des Leitungswiderstandes $R_L$ (7),
     • wobei die Zeitdauer aller Verfahrensschritte nach Ablauf des Zeitintervalls $\Delta t_1$ das Messzeitintervall $\Delta t_M$ bestimmt.

3. Verfahren nach Anspruch 2, **dadurch gekennzeichnet, dass** der Leitungswiderstand $R_L$ (7) berechnet wird, durch Bilden des Quotienten aus der Differenz der Spannungswerte $U_1$ und $U_2$ und der Differenz der zugehörigen Ströme.

4. Verfahren nach einem der Ansprüche 1 bis 3, **dadurch gekennzeichnet, dass** die Messung des Leitungswiderstandes $R_L$ (7) periodisch, aperiodisch und/oder auf Anforderung erfolgt.

5. Verfahren nach einem der Ansprüche 1 bis 4, **dadurch gekennzeichnet, dass** bei Überschreiten eines vordefinierten Grenzwertes für den Leitungswiderstand $R_L$ (7), der Mikrocontroller (1) ein Störungssignal erzeugt, welches eine Störung der Steuerleitungen (16) signalisiert.

6. Verfahren nach Anspruch 5, **dadurch gekennzeichnet, dass** als Störung der Steuerleitungen (16) ein schleichender Drahtbruch erkannt wird.

7. Verfahren nach Anspruch 5, **dadurch gekennzeichnet, dass** als Störung der Steuerleitungen (16) eine fehlerhafte Installation mit erhöhten Werten des Leitungswiderstandes $R_L$ (7) der Steuerleitungen (16) erkannt wird.

8. Verfahren nach Anspruch 5, **dadurch gekennzeichnet, dass** die Störung der Steuerleitungen (16) optisch und/oder akustisch angezeigt wird.

9. **Vorrichtung** zur Messung eines Leitungswiderstandes $R_L$ (7) und somit zur Bestimmung von Störungen von Steuerleitungen (16) in einem Gefahrenmelde- und Steuerungssystem umfassend:

     eine Steuerungsvorrichtung (20), welche eine über einen Mikrocontroller (1) zuschaltbare Konstantstromsenke (6) oder einen zuschaltbaren Lastwiderstand, eine Umschaltvorrichtung (5) und eine Spannungsquelle (4) zur Erzeugung einer Überwachungsspannung UM aufweist, und

ein Überwachungsmodul (21), welches am Ende der Steuerleitungen (16) an oder in einem Aktor (10) angeordnet ist, wobei der Anfang der Steuerleitungen (16) an der Steuerungsvorrichtung (20) angeordnet ist, wobei das Überwachungsmodul (21) einen Energiespeicher (9) zur Erzeugung und Zurückspeisung in die Steuerungsvorrichtung (20) einer konstanten Spannungsversorgung in einem Messzeitintervall $\Delta t_M$ zur Bestimmung des Leitungswiderstandes $R_L$ (7) aufweist und wobei die Umschaltvorrichtung (5) und der Mikrocontroller (1) so ausgeprägt und ausgebildet sind, dass im gesamten Messzeitintervall $\Delta t_M$ die Spannungsversorgung des Aktors (10) mit der Überwachungsspannung $U_M$ von Seiten der Steuerungsvorrichtung (20) abgeschaltet ist.

10. Vorrichtung nach Anspruch 9, **dadurch gekennzeichnet, dass** die Steuerungsvorrichtung (20) so eingerichtet und ausgebildet ist, dass die Umschaltvorrichtung (5) über den Mikrocontroller (1) steuerbar ist, für die Abschaltung der Spannungsversorgung des Aktors (10) und/oder für die Ansteuerung des Aktors (10) mit einer Ansteuerspannung $U_A$ im Ereignisfall.

11. Vorrichtung nach einem der Ansprüche 9 oder 10 **dadurch gekennzeichnet, dass** die Steuerungsvorrichtung (20) zur periodischen und/oder aperiodischen Messung des Leitungswiderstandes $R_L$ (7) und/oder zur Messung auf Anforderung ausgebildet ist.

12. Vorrichtung nach einem der Ansprüche 9 bis 11, **dadurch gekennzeichnet, dass** das Überwachungsmodul (21) ein zum Innenwiderstand des Aktors (10) in Reihe geschalteten Abschlusswiderstand $R_{EOL}$ (12), einen Schwellwertschalter (14) und einen Schalter (13) aufweist, wobei der Abschlusswiderstand $R_{EOL}$ so ausgelegt ist, dass bei Anliegen der Überwachungsspannung UM die am Aktor (10) anliegende Spannung unterhalb der minimalen Ansteuerspannung liegt.

13. Vorrichtung nach einem der Ansprüche 9 bis 12, **dadurch gekennzeichnet, dass** die Steuerungsvorrichtung (20) so eingerichtet und ausgebildet ist, dass bei Überschreiten eines vordefinierten Grenzwertes für den Leitungswiderstand $R_L$ (7), durch den Mikrocontroller (1) ein Störungssignal erzeugt wird, welches eine Störung der Steuerleitungen (16) signalisiert.

14. Vorrichtung nach einem der Ansprüche 9 bis 13, **dadurch gekennzeichnet, dass** der Energiespeicher (9) einen Kondensator oder eine Batterie darstellt, welche so dimensioniert sind, dass sie die konstante Spannungsversorgung im Messzeitintervall $\Delta t_M$ gewährleisten.

15. Vorrichtung nach einem der Ansprüche 9 bis 14, **dadurch gekennzeichnet, dass** der Aktor (10) ein Magnetventil darstellt.

16. Vorrichtung nach einem der Ansprüche 9 bis 15, **dadurch gekennzeichnet, dass** die Steuerungsvorrichtung (20) als Bestandteil einer Brandmelder- und/oder Löschsteuerzentrale (23) ausgeprägt ist.

17. Vorrichtung nach Ansprüche 16, **dadurch gekennzeichnet, dass** die Steuerungsvorrichtung (20) ein Steuergruppenmodul (24) darstellt.

18. Vorrichtung nach einem der Ansprüche 9 bis 17, **dadurch gekennzeichnet, dass** die Steuerungsvorrichtung (20) als ein adressierbares Modul auf einer Ringbusleitung der Brandmelder- und/oder Löschsteuerzentrale (23) ausgebildet ist.

**Claims**

1. **A method** for measuring a line resistance $R_L$ (7) and thus for determining faults of control lines (16) in a hazard warning and control system, the control lines (16) connecting a control device (20) to an actuator (10), the control device (20) in the case of an incident driving the actuator (10) using a drive voltage $U_A$ and in the case of monitoring supplying the actuator (10) with a monitoring voltage $U_M$, there being arranged at or in the actuator (10) a monitoring module (21) at the end of the control lines (16), the control device (20) furthermore exhibiting a constant current sink (6) connectable via a microcontroller (1) or a connectable load resistance and a switching device (5) and the beginning of the control lines (16) being arranged on the control device (20), wherein for determining the line resistance $R_L$ (7) a constant voltage supply is provided in a measurement time interval $\Delta t_M$ by means of an energy storage (9) integrated into the monitoring module (21), fed back into the control device (20), and in the entire measurement time interval $\Delta t_M$ the switching device (5) switches off the supply of monitoring voltage $U_M$ provided by the control device (20) for the actuator (10).

2. The method according to Claim 1, **characterized in that** the following method steps are carried out:

- providing a monitoring voltage $U_M$ at the contacts (17) of the control device (20) for electrically tying the control lines (16) for the duration of a time interval $\Delta t_1$,
- charging the energy storage (9) of the monitoring module (21) by means of the applied monitoring voltage $U_M$ for the duration of the time interval $\Delta t_1$,
- switching off the monitoring voltage $U_M$ after the expiration of the time interval $\Delta t_1$,
- generating a regulated voltage $U_0$ from the energy storage (9) using a voltage regulator (8),
- measuring a resulting voltage value $U_1$ at the contacts (17) using an A/D converter (2) and storing the voltage value $U_1$ in a memory (22),
- driving the constant current sink (6) by means of the microcontroller (1) and impressing a current value $I_2$ into the control lines (16),
- measuring a voltage value $U_2$ using the A/D converter (2) at the contacts (17), that is generated by the impressed current value $I_2$,
- storing the voltage value $U_2$ in the memory (22) and
- calculating the line resistance $R_L$ (7),
- the duration of all method steps after the expiration of the time interval $\Delta t_1$ determining the measurement time interval $\Delta t_M$.

3. The method according to Claim 2, **characterized in that** the line resistance $R_L$ (7) is calculated by forming the quotient from the difference of the voltage values $U_1$ and $U_2$ and the difference of the associated currents.

4. The method according to one of Claims 1 to 3, **characterized in that** measurement of the line resistance $R_L$ (7) takes place periodically, aperiodically and/or on demand.

5. The method according to one of Claims 1 to 4, **characterized in that** when a predefined limit value for the line resistance $R_L$ (7) is exceeded, the microcontroller (1) generates a fault signal that signals a fault of the control lines (16).

6. The method according to Claim 5, **characterized in that** a slow developing wire breakage is detected as a fault of the control lines (16).

7. The method according to Claim 5, **characterized in that** faulty installation with increased values of the line resistance $R_L$ (7) of the control lines (16) is detected as fault of the control lines (16).

8. The method according to Claim 5, **characterized in that** the fault of the control lines (16) is indicated optically and/or acoustically.

9. **A device** for measuring a line resistance $R_L$ (7) and thus for determining faults of control lines (16) in a hazard warning and control system, comprising:

a control device (20) that exhibits a constant current sink (6) connectable via a microcontroller (1) or a connectable load resistance, a switching device (5) and a voltage source (4) for generating a monitoring voltage $U_M$, and
a monitoring module (21) that is arranged at the end of the control lines (16) at or in an actuator (10), the beginning of the control lines (16) being arranged at the control device (20), wherein the monitoring module (21) exhibits an energy storage (9) for generating and feeding-back a constant voltage supply into the control device (20) in a measurement time interval $\Delta t_M$ for determining the line resistance $R_L$ (7), and wherein the switching device (5) and the microcontroller (1) being designed and formed such that the supply of monitoring voltage $U_M$ provided by the control device (20) for the actuator (10), is switched off in the entire measurement time interval $\Delta t_M$.

10. The device according to Claim 9, **characterized in that** the control device (20) is set up and designed such that the switching device (5) can be controlled by means of the microcontroller (1), for switching off the voltage supply of the actuator (10) and/or for driving the actuator (10) using a drive voltage $U_A$ in the event of an incident.

11. The device according to one of Claims 9 or 10, **characterized in that** the control device (20) is designed for periodically and/or aperiodically measuring the line resistance $R_L$ (7) and/or for measuring on demand.

12. The device according to one of Claims 9 to 11, **characterized in that** the monitoring module (21) exhibits a terminating resistance $R_{EOL}$ (12) connected in series to an inside resistance of the actuator (10), a limit-value switch (14) and a switch (13), the terminating resistance $R_{EOL}$ being designed such that the voltage applied to the actuator (10) is below the minimum drive voltage when the monitoring voltage $U_M$ is applied.

13. The device according to one of Claims 9 to 12, **characterized in that** the control device (20) is set up and designed such that when a predefined limit value for the line resistance $R_L$ (7) is exceeded the microcontroller (1) generates a fault signal that signals a fault of the control lines (16).

14. The device according to one of Claims 9 to 13, **characterized in that** the energy storage (9) represents a capacitor or a battery that are dimensioned such that they ensure a constant voltage supply during the measurement time interval $\Delta t_M$.

15. The device according to one of Claims 9 to 14, **characterized in that** the actuator (10) represents a solenoid valve.

16. The device according to one of Claims 9 to 15, **characterized in that** the control device (20) is designed as constituent part of a fire detection panel and/or extinguishing control panel (23).

17. The device according to Claim 16, **characterized in that** the control device (20) represents a control group module (24).

18. The device according to one of Claims 9 to 17, **characterized in that** the control device (20) is designed as an addressable module on a ring bus line of the fire detection panel and/or extinguishing control panel (23).

**Revendications**

1. **Procédé** de mesure d'une résistance de ligne $R_L$ (7) et donc de détection de pannes sur lignes de commande (16) dans un système de signalisation de danger et de commande, les lignes de commande (16) reliant un dispositif de commande (20) à un actionneur (10), le dispositif de commande (20) excitant en cas d'événement l'actionneur (10) par une tension d'excitation $U_A$ et alimentant en cas de surveillance l'actionneur (10) par une tension de surveillance $U_M$, un module de surveillance (21) étant disposé sur ou dans l'actionneur (10) à l'extrémité des lignes de commande (16), le dispositif de commande (20) présentant en outre un puits de courant constant (6) connectable par l'intermédiaire d'un microcontrôleur (1) ou une résistance de charge connectable et un dispositif de commutation (5), et le début des lignes de commande (16) étant disposé au niveau du dispositif de commande (20), une alimentation en tension constante étant mise à disposition sur un intervalle de temps de mesure $\Delta t_M$ pour la détermination de la résistance de ligne $R_L$ (7) par un accumulateur d'énergie (9) intégré au module de surveillance (21) et étant réinjectée dans le dispositif de commande (20), le dispositif de commutation (5) coupant l'alimentation en tension de surveillance $U_M$, issue du dispositif de commande (20), pour l'actionneur (10) sur tout l'intervalle de temps de mesure $\Delta t_M$ à l'aide de la tension de surveillance $U_M$.

2. Procédé selon la revendication 1, **caractérisé en ce que** sont exécutées les étapes suivantes :

• mise à disposition d'une tension de surveillance $U_M$ sur les contacts (17) du dispositif de commande (20) en vue de la connexion électrique des lignes de commande (16) pour la durée d'un intervalle de temps $\Delta t_1$,
• charge de l'accumulateur d'énergie (9) du module de surveillance (21) par la tension de surveillance $U_M$ appliquée pour la durée de l'intervalle de temps $\Delta t_1$,
• coupure de la tension de surveillance $U_M$ à l'expiration de l'intervalle de temps $\Delta t_1$,
• génération d'une tension régulée $U_0$ à partir de l'accumulateur d'énergie (9) à l'aide d'un régulateur de tension (8),
• mesure d'une valeur de tension résultante $U_1$ sur les contacts (17) à l'aide d'un convertisseur A/N (2) et enregistrement de la valeur de tension $U_1$ dans une mémoire (22),
• excitation du puits de courant constant (6) par le microcontrôleur (1) et injection d'une valeur de courant $I_2$ dans les lignes de commande (16),
• mesure à l'aide du convertisseur A/N (2), sur les contacts (17), d'une valeur de tension $U_2$ résultant de la valeur de courant injectée $I_2$,
• enregistrement de la valeur de tension $U_2$ dans la mémoire (22), et
• calcul de la résistance de ligne $R_L$ (7),
• la durée de toutes les étapes à l'expiration de l'intervalle de temps $\Delta t_1$ déterminant l'intervalle de temps de mesure $\Delta t_M$.

3. Procédé selon la revendication 2, **caractérisé en ce que** la résistance de ligne $R_L$ (7) se calcule en faisant le quotient de la différence des valeurs de tension $U_1$ et $U_2$ et de la différence des courants associés.

4. Procédé selon l'une des revendications 1 à 3, **caractérisé en ce que** la mesure de la résistance de ligne $R_L$ (7) est périodique, apériodique et/ou opérée sur demande.

5. Procédé selon l'une des revendications 1 à 4, **caractérisé en ce qu'**en cas de dépassement d'une valeur limite prédéfinie pour la résistance de ligne $R_L$ (7), le microcontrôleur (1) génère un signal de panne signalant une panne des lignes de commande (16).

6. Procédé selon la revendication 5, **caractérisé en ce qu'**une rupture progressive de fil est détectée comme panne des lignes de commande (16).

7. Procédé selon la revendication 5, **caractérisé en ce qu'**une installation défectueuse, avec des valeurs trop élevées de la résistance de ligne $R_L$ (7) des lignes de commande (16), est détectée comme panne des lignes de commande (16).

**8.** Procédé selon la revendication 5, **caractérisé en ce que** la panne des lignes de commande (16) est indiquée par des moyens visuels et/ou acoustiques.

**9.** **Dispositif** de mesure d'une résistance de ligne $R_L$ (7) et donc de détection de pannes sur lignes de commande (16) dans un système de signalisation de danger et de commande, comprenant :

un dispositif de commande (20) présentant un puits de courant constant (6) connectable par l'intermédiaire d'un microcontrôleur (1) ou une résistance de charge connectable, un dispositif de commutation (5) et une source de tension (4) destinée à générer une tension de surveillance $U_M$, et
un module de surveillance (21) disposé sur ou dans un actionneur (10) à l'extrémité des lignes de commande (16), le début des lignes de commande (16) étant disposé au niveau du dispositif de commande (20), le module de surveillance (21) présentant un accumulateur d'énergie (9) destiné à générer et à réinjecter dans le dispositif de commande (20) une alimentation en tension constante sur un intervalle de temps de mesure $\Delta t_M$ pour la détermination de la résistance de ligne $R_L$ (7), et le dispositif de commutation (5) et le microcontrôleur (1) étant conçus et configurés de telle manière que l'alimentation en tension surveillance $U_M$, issue du dispositif de commande (20) pour de l'actionneur (10) soit coupée sur tout l'intervalle de temps de mesure $\Delta t_M$.

**10.** Dispositif selon la revendication 9, **caractérisé en ce que** le dispositif de commande (20) est conçu et configuré de telle manière que le dispositif de commutation (5) est pilotable par le microcontrôleur (1), pour la coupure de l'alimentation en tension de l'actionneur (10) et/ou l'excitation de l'actionneur (10) par une tension d'excitation $U_A$ en cas d'événement.

**11.** Dispositif selon l'une des revendications 9 ou 10, **caractérisé en ce que** le dispositif de commande (20) est configuré pour la mesure périodique et/ou apériodique de la résistance de ligne $R_L$ (7) et/ou pour la mesure sur demande.

**12.** Dispositif selon l'une des revendications 9 à 11, **caractérisé en ce que** le module de surveillance (21) présente une résistance terminale $R_{EOL}$ (12) montée en série avec la résistance interne de l'actionneur (10), un interrupteur à seuil (14) et un interrupteur (13), la résistance terminale $R_{EOL}$ étant dimensionnée de telle manière qu'à l'application de la tension de surveillance $U_M$, la tension appliquée à l'actionneur (10) soit inférieure à la tension minimale d'excitation.

**13.** Dispositif selon l'une des revendications 9 à 12, **caractérisé en ce que** le dispositif de commande (20) est conçu et configuré de telle manière qu'en cas de dépassement d'une valeur limite prédéfinie pour la résistance de ligne $R_L$ (7), le microcontrôleur (1) génère un signal de panne signalant une panne des lignes de commande (16).

**14.** Dispositif selon l'une des revendications 9 à 13, **caractérisé en ce que** l'accumulateur d'énergie (9) est constitué d'un condensateur ou d'une batterie, dimensionnés de manière à assurer l'alimentation en tension constante sur l'intervalle de temps de mesure $\Delta t_M$.

**15.** Dispositif selon l'une des revendications 9 à 14, **caractérisé en ce que** l'actionneur (10) est constitué d'une électrovanne.

**16.** Dispositif selon l'une des revendications 9 à 15, **caractérisé en ce que** le dispositif de commande (20) fait partie intégrante d'une centrale d'alarme et/ou d'extinction d'incendie (23).

**17.** Dispositif selon la revendication 16, **caractérisé en ce que** la dispositif de commande (20) est constitué d'un module de groupe de commande (24).

**18.** Dispositif selon l'une des revendications 9 à 17, **caractérisé en ce que** le dispositif de commande (20) se présente sous la forme d'un module adressable sur un bus de la centrale d'alarme et/ou d'extinction d'incendie (23).

Fig. 1

Fig. 2

EP 2 804 163 B1

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1855261 A1
- WO 2009087169 A
- FR 2932917 A1
- EP 2093737 A1